Europäisches Patentamt

European Patent Office

Office européen des brevets

(11) Veröffentlichungsnummer: **0 059 271**
**A1**

(12) # EUROPÄISCHE PATENTANMELDUNG

(21) Anmeldenummer: **81200247.5**

(22) Anmeldetag: **04.03.81**

(51) Int. Cl.³: **H 02 M 1/08**
**H 02 M 3/135**

(43) Veröffentlichungstag der Anmeldung:
**08.09.82 Patentblatt 82/36**

(84) Benannte Vertragsstaaten:
**AT BE CH DE FR GB IT LI LU NL SE**

(71) Anmelder: **BBC Aktiengesellschaft Brown, Boveri & Cie.**

**CH-5401 Baden(CH)**

(72) Erfinder: **Hauswirth, Christian**
**Treppenweg 21**
**CH-5300 Ennetturgi(CH)**

(54) **Verfahren und Einrichtung zur Erzeugung eines Gateimpulses für die Zündung eines Hauptthyristors.**

(57) Zur Erzeugung eines Gateimpulses für die Zündung eines Hauptthyristors (T) wird ein lichtzündbarer Hilfsthyristor (TA) verwendet und die für das Einschalten des Hauptthyristors (T) notwendige Energie wird aus einem Beschaltungskondensator (C1) ausgekoppelt. In bezug auf die Eingangsspannung und die zulässige Spannungsbeanspruchung der konkret gewählten Hauptthyristoren (T) kann man selbstverständlich auch z.B. eine Serieschaltung von mehreren Hauptthyristoren (T) verwenden. Mit der erfindungsgemässen Lösung erreicht man eine Verlängerung des Zündimpulses, womit eventuelle Nachzündungen ermöglicht werden. Der vorliegende Gegenstand ist insbesondere für Hochspannungs-Stromrichter geeignet.

FIG.1

0059271

16/81
PL/eh

- 1 -

## Verfahren und Einrichtung zur Erzeugung eines Gateimpulses für die Zündung eines Hauptthyristors

Die vorliegende Erfindung bezieht sich auf ein Verfahren und eine Einrichtung zur Erzeugung eines Gateimpulses für die Zündung eines Hauptthyristors.

Die Potentialtrennung bei der Zündung von Thyristoren erfolgt zur Zeit mittels Impulsübertrager. Es wird ein Zündimpuls gewünschter Länge und Dauer erzeugt und induktiv übertragen. Eine Lösung dieser Art ist in "Brown Boveri Mitteilungen", Nr. 12-1975 auf Seiten 520 und 521 im Artikel "Konzeption der Steuer- und Regelelektronik auf Triebfahrzeugen mit Anschnittsteuerung" beschrieben. Der konstruktive Aufbau weist eine komplizierte und anfällige Elektronik auf.

Die Aufgabe der vorliegenden Erfindung ist, die Nachteile des Bekannten zu beseitigen und eine Verlängerung des Zündimpulses mit einfachen Mitteln und somit eine Energie für eventuelle Nachzündungen zu erreichen.

- 2 -

Die vorgenannte Aufgabe wird durch die in den Ansprüchen gekennzeichnete Erfindung gelöst.

Die durch die Erfindung erreichten Vorteile sind im wesentlichen darin zu sehen, dass der Beschaltungskondensator die notwendige Energie durch entsprechende Dimensionierung ausreichend speichern und zur Verlängerung des Zündimpulses wieder liefern kann.

Im folgenden wird die Erfindung anhand von zwei Ausführungsbeispielen näher erläutert.

Es zeigt

Fig. 1 eine beispielsweise erfindungsgemässe Einrichtung zur Erzeugung eines Gateimpulses für die Zündung eines Hauptthyristors und

Fig. 2 eine beispielsweise erfindungsgemässe Einrichtung mit drei in Serie geschalteten Hauptthyristoren, wobei jeder Hauptthyristor in einer eigenen Funktionseinheit eingeschaltet ist.

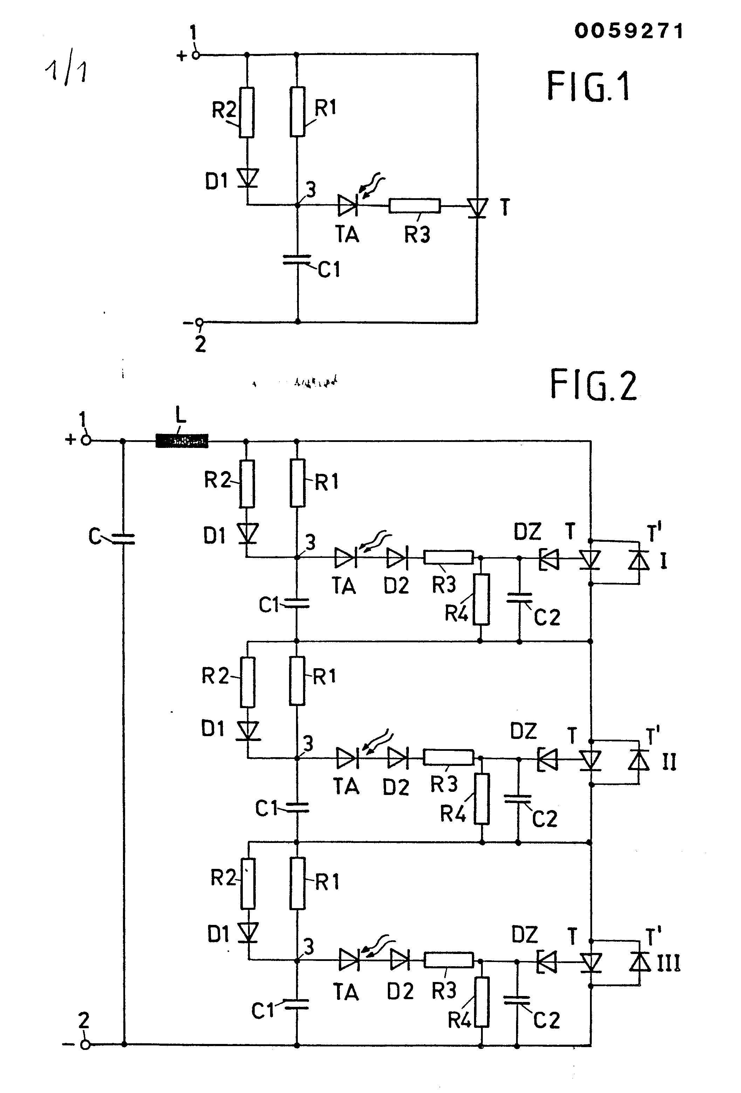

Gemäss Fig. 1 ist ein Hauptthyristor T zwischen dem Plus-Anschluss 1 und dem Minus-Anschluss 2 eingeschaltet, wobei parallel zu diesem Hauptthyristor T eine Beschaltung C1, R1 angeschlossen ist, die aus einer Serienschaltung eines Beschaltungskondensators C1 und eines Beschaltungswiderstandes R1 besteht. Parallel zu dem Beschaltungswiderstand R1 ist ein Dämpfungswiderstand R2 angeschlossen, der mit einer Entkopplungsdiode D1 entkoppelt ist. Der Verbindungspunkt 3 des Beschaltungskondensators C1 und des Beschaltungswiderstandes R1 ist mit dem Anodenanschluss eines lichtzündbaren

- 3 -

Hilfsthyristors TA verbunden, dessen Kathode über einen Begrenzungswiderstand R3 an den Steueranschluss des Hauptthyristors T führt. Der lichtzündbare Hilfsthyristor TA wird mittels eines Lichtimpulses eingeschaltet. Der Hauptthyristor T schaltet ein. Die Spannung zwischen dem Plus-Anschluss 1 und dem Minus-Anschluss 2 bricht auf den Durchlasswert des Hauptthyristors T zusammen. Die im Beschaltungskondensator C1 gespeicherte Energie fliesst teilweise weiter über den lichtzündbaren Hilfsthyristor TA und den Begrenzungswiderstand R3 an den Steueranschluss des Hauptthyristors T. Der übrige Teil der Energie des Beschaltungskondensators C1 fliesst durch den Beschaltungswiderstand R1 über den Hauptthyristor T. Mit dieser Anordnung ist sichergestellt, dass der Steuerstrom für den Hauptthyristor T solange fliesst, bis dieser seinen Einraststrom erreicht hat. Der Dämpfungswiderstand R2 mit der Entkopplungsdiode D1 dient der Dämpfung des Spannungsanstieges beim Wiedereinschalten der Spannung zwischen den Anschlüssen 1 und 2. Die beschriebene Einrichtung ist auch ohne den Dämpfungswiderstand R2 und ohne die Entkopplungsdiode D1 funktionsfähig. Der Dämpfungswiderstand R2 mit der Begrenzungsdiode D1 verhindern jedoch einen eventuellen unzulässig hohen, dynamischen Spannungsanstieg beim Spannungseinschalten.

Fig. 2 zeigt eine Serienschaltung von drei Hauptthyristoren T, die in bezug auf die Eingangsspannung und die zulässige Spannungsbeanspruchung der konkret gewählten Hauptthyristoren T verwendet wurde. Die Figur 2 stellt drei Funktionseinheiten I, II und III dar, die den einzelnen Hauptthyristoren T zugeordnet sind. Jede der Funktionseinheiten I, II, III entspricht im wesentlichen der Ausführungsform gemäss Fig. 1, wobei auch dieselben Teile mit gleichen Bezeichnungen versehen sind. Zusätzlich, um die Verbindung der Funk-

- 4 -

tionseinheiten I, II, III zu ermöglichen, sind weitere Bestandteile verwendet worden. Eine Gatebeschaltung, bestehend aus einer Zener-Diode DZ und einer Parallelschaltung aus einem Kondensator C2 und einem Widerstand R4, die zwischen Gate und Kathode des Hauptthyristors T geschaltet sind, verhindert das Einschalten des Hauptthyristors T durch Störladungen. Der Hauptthyristor T ist als rückwärtsleitender Thyristor mit einer in Silicium integrierter Freilaufdiode T' ausgeführt. Diese konstruktive Einheit, die aus dem Hauptthyristor T und der Freilaufdiode T' besteht, ist in Fig. 2 wegen der Anschaulichkeit getrennt gezeichnet. Die Hilfsdiode D2 nimmt eventuell auftretende negative Spannungen zwischen der Gatebeschaltung DZ, C2, R4 und dem Beschaltungskondensator C1 auf. Wenn die Hauptthyristoren T mittels der lichtzündbaren Hilfsthyristoren TA eingeschaltet werden, schwingt die in einem Eingangskondensator C gespeicherte Energie über eine Drossel L um.

Es ist selbstverständlich, dass an Stelle des beschriebenen Hauptthyristors T in an sich bekannter Weise eine Parallelschaltung von mehreren Hauptthyristoren verwendet werden kann, die dann eine Funktionseinheit bilden. Die erwähnten lichtzündbaren Thyristoren sind an sich bekannt und z.B. in V.A.K. Temple: "Light Triggered Thyristors for HVDC Applications", IEEE Trans. PES, April 1979, S. 213 beschrieben.

Das erfindungsgemässe, potentialfreie und störungssichere Zünden von Hauptthyristoren T ist insbesondere für Hochspannungs-Stromrichter geeignet.

-5-

Bezeichnungsliste

| | |
|---|---|
| T | Hauptthyristor |
| TA | lichtzündbarer Hilfsthyristor |
| C1 | Beschaltungskondensator |
| R1 | Beschaltungswiderstand |
| R2 | Dämpfungswiderstand |
| R3 | Begrenzungswiderstand |
| 1 | Plus-Anschluss |
| 2 | Minus-Anschluss |
| 3 | Verbindungspunkt |
| D1 | Entkopplungsdiode |
| D2 | Hilfsdiode |
| C2 | Kondensator der Gatebeschaltung |
| R4 | Widerstand der Gatebeschaltung |
| DZ | Zenerdiode |
| T' | Freilaufdiode |
| I, II, III | Funktionseinheiten |
| C | Eingangskondensator |
| L | Eingangsdrossel |

========================

-6-

Patentansprüche

1. Verfahren zur Erzeugung eines Gateimpulses für die Zündung eines Hauptthyristors (T), dadurch gekennzeichnet, dass der Hauptthyristor (T) mittels eines lichtzündbaren Hilfsthyristors (TA) eingeschaltet wird und dass die für das Einschalten des Hauptthyristors (T) notwendige Energie aus einem Beschältungskondensator (C1) ausgekoppelt wird.

2. Einrichtung zur Durchführung des Verfahrens nach Anspruch 1, dadurch gekennzeichnet, dass an den Steueranschluss des Hauptthyristors (T) kathodenseitig ein lichtzündbarer Hilfsthyristor (TA) angeschlossen ist, dessen Anode an einen Verbindungspunkt (3) einer aus einem Beschaltungskondensator (C1) und einem Beschaltungswiderstand (R1) bestehenden Beschaltung angeschlossen ist, wobei die Beschaltung (C1, R1) mit dem Beschaltungskondensator (C1) an die Kathode des Hauptthyristors (T) und mit dem Beschaltungswiderstand (R1) an die Anode des Hauptthyristors (T) angeschlossen ist.

3. Einrichtung nach Anspruch 2, dadurch gekennzeichnet, dass die Kathode des lichtzündbaren Hilfsthyristors (TA) mit dem Steueranschluss des Hauptthyristors (T) über einen Begrenzungswiderstand (R3) verbunden ist.

4. Einrichtung nach Anspruch 2, dadurch gekennzeichnet, dass die Kathode des lichtzündbaren Hilfsthyristors (TA) mit der Anode einer Hilfsdiode (D2) verbunden ist, deren Kathode an den Steueranschluss des Hauptthyristors (T) angeschlossen ist.

FIG.1

FIG.2

0059271

16/81

Europäisches
Patentamt

**EUROPÄISCHER RECHERCHENBERICHT**

**0059271**
Nummer der Anmeldung

EP 81 20 0247

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | CH-A- 444 287 (SVENSKA) <br> * Spalte 2, Zeile 1 - Spalte 6, Zeile 16 * | 1-4 | H 02 M 1/08 <br> H 02 M 3/135 |
| X | CH-A- 478 480 (SVENSKA) <br> * Spalte 2, Zeile 20 - Spalte 4, Zeile 41 * | 1-4 | |
| X | DE-A-1 538 099 (SIEMENS) <br> * Seite 3, Zeile 15 - Seite 6, Zeile 21 * | 1-4 | |

RECHERCHIERTE
SACHGEBIETE (Int. Cl. ³)

H 02 M 1/00
H 02 M 3/00

Der vorliegende Recherchenbericht wurde für alle Patentansprüche erstellt.

| Recherchenort <br> DEN HAAG | Abschlußdatum der Recherche <br> 07-06-1982 | Prüfer <br> BERTIN M.H.J. |
|---|---|---|

KATEGORIE DER GENANNTEN DOKUMENTEN
X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82